# EUROPÄISCHE PATENTSCHRIFT

(11) **EP 2 177 302 B1**
(45) Veröffentlichungstag und Bekanntmachung des Hinweises auf die Patenterteilung: **23.01.2013**
(21) Anmeldenummer: 09012672.3
(22) Anmeldetag: 07.10.2009
(51) Int. Cl.: B23K 26/36, B23K 26/40, H01L 27/142, H01L 31/0224

(54) **Verfahren zum Abtragen von Schichtmaterial eines Schichtaufbaus mittels Laserstrahlung mit einem Hilfsgrabenschritt und einem Abtragschritt**
Method of removing layered material of a layered construction with a laser beam, with a preliminary grooving step and a removing step
Procédé d'enlèvement de matériau d'une construction en couche à l'aide d'un rayonnement laser avec une étape préliminaire d'ablation et une étape d'enlèvement

(30) Priorität: 15.10.2008 DE 102008053595
(43) Veröffentlichungstag der Anmeldung: 21.04.2010
(73) Patentinhaber: Zentrum für Sonnenenergie- und Wasserstoff-Forschung Baden-Württemberg Gemeinnützige Stiftung, 70565 Stuttgart (DE)
(72) Erfinder: Lotter, Erwin, Dr., 74354 Besigheim (DE)
(74) Vertreter: Patentanwälte Ruff, Wilhelm, Beier, Dauster & Partner

(56) Entgegenhaltungen:
- WO-A1-2008/050556
- DE-A1- 19 934 560
- JP-A- 2008 066 453
- US-A1- 2006 266 409

## Beschreibung

Die Erfindung bezieht sich auf ein Verfahren zum Abtragen von Schichtmaterial eines Schichtaufbaus auf einem Trägersubstrat mittels Laserstrahlung, wobei der Schichtaufbau eine untere und eine obere elektrisch leitfähige Schicht und eine zwischenliegende Zwischenschicht umfasst, die ihrerseits aus einer oder mehreren Schichtlagen, d.h. Einzelschichten, bestehen kann. Insbesondere kann es sich um eine Zwischenschicht handeln, die unter der Einwirkung der Laserstrahlung zur Ausbildung von Pfaden mit erhöhter elektrischer Leitfähigkeit entlang eines entsprechenden Bearbeitungsrandes neigt, sei es, dass die Zwischenschicht zunächst elektrisch nichtleitend ist und sich darin ein oder mehrere elektrisch leitfähige Pfade ausbilden, sei es, dass die Zwischenschicht bereits eine gewisse elektrische Leitfähigkeit besitzt, die dann entlang eines oder mehrerer solcher Pfade merklich gesteigert wird. Ein wichtiges Anwendungsgebiet, für das sich die Erfindung eignet, betrifft das Abtragen von Schichtmaterial in einem Photovoltaik-Mehrschichtaufbau zur sogenannten Randentschichtung entsprechender Photovoltaikmodule und zur Einbringung von Trenngräben zwecks Strukturierung integriert serienverschalteter Photovoltaikmodule. In diesem Fall ist die Zwischenschicht der Schichtaufbau zwischen einer Front- und einer Rückkontaktschicht, der insbesondere eine sogenannte Absorberschicht als photovoltaisch aktive Schicht beinhaltet.

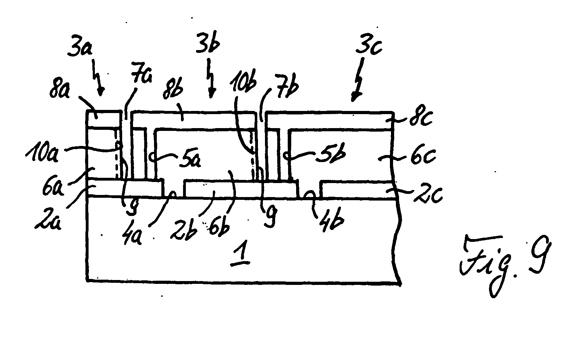

Das letztgenannte Strukturieren von integriert serienverschalteten Photovoltaikmodulen ist beispielsweise in der Patentschrift DE 199 34 560 B4 und dem dort zitierten Stand der Technik beschrieben. Die Trenngräben können photolithographisch erzeugt werden, was jedoch einen vergleichsweise hohen Fertigungsaufwand bedeutet. Traditionell werden daher die Trenngräben meist mechanisch durch eine Ritz- oder Schneidtechnik eingebracht. Auch diese Vorgehensweise erweist sich jedoch als ziemlich zeit- und kostenintensiv und zudem als relativ fehleranfällig z.B. aufgrund von Verschleiß des mechanischen Ritz-/Schneidwerkzeugs. Als eine mögliche Alternative zur Vermeidung dieser Probleme kommt das Erzeugen der Trenngräben mittels Laserstrahlung in Betracht. Hierbei ergibt sich aber eine Kurzschlussproblematik, die in Fig. 9 veranschaulicht ist.

Fig. 9 zeigt in einem ausschnittweisen, idealisierten Querschnitt einen hier interessierenden Teil eines Photovoltaikmoduls mit einem Mehrschichtaufbau in üblicher Photovoltaik-Dünnschichttechnologie. Auf ein Substrat 1, z.B. ein transparentes Glassubstrat, wird ganzflächig ein Rückkontaktmaterial, z.B. aus Molybdän, aufgebracht, das dann durch einen ersten Strukturierungsprozess in Rückkontakte 2a, 2b, 2c für einzelne Solarzellen 3a, 3b, 3c strukturiert wird, indem das Rückkontaktmaterial entlang zugehöriger erster Strukturierungslinien 4a, 4b entfernt wird. Anschließend wird ganzflächig eine photovoltaisch aktive Schicht, d.h. die Absorberschicht, gebildet und durch Einbringen zugehöriger zweiter Strukturierungslinien 5a, 5b in nebeneinanderliegende, photovoltaisch aktive Schichten 6a, 6b, 6c für die einzelnen Solarzellen 3a, 3b, 3c unterteilt. Die Absorberschicht kann z.B. aus einem üblichen Verbindungshalbleitermaterial, wie einem sogenannten CIS- oder CIGS-Material mit Kupfer, Indium und/oder Gallium sowie Schwefel und/oder Selen, und einlagig oder mehrlagig gebildet sein. Anschließend wird ein Frontkontaktmaterial ganzflächig aufgebracht und durch Einbringen dritter Strukturierungslinien 7a, 7b in einzelne Frontkontakte 8a, 8b, 8c für die Einzelzellen 3a, 3b, 3c unterteilt. Die dritten Strukturierungslinien 7a, 7b erstrecken sich dazu mindestens bis zur Absorberschicht und können sich optional in beliebiger Tiefe in die Absorberschicht erstrecken, z.B. auch wie im gezeigten Beispiel bis zum zugehörigen Rückkontakt 2a, 2b, 2c.

Wie aus Fig. 9 erkennbar, bilden die zweiten Strukturierungslinien 5a, 5b Verbindungsbereiche, in denen der Frontkontakt 8a, 8b, 8c einer jeweiligen Zelle 3a, 3b, 3c mittels Berührkontakt elektrisch mit dem Rückkontakt 2a, 2b, 2c einer lateral benachbarten Zelle verbunden ist, was insgesamt zur gewünschten integrierten Serienverschaltung der nebeneinanderliegenden Einzelzellen 3a, 3b, 3c führt.

Wenn die dritten Strukturierungslinien 7a, 7b mittels Laserstrahlung erzeugt werden, wurde beobachtet, dass Kurzschlusspfade entlang deren Randbereich 9 auftreten können, speziell im von der Laserstrahlung beeinflussten Halbleitermaterial der Absorberschicht 6a, 6b, 6c, z.B. im Fall eines CIS- oder CIGS-Halbleitermaterials. Dies wird dem thermischen Eintrag in das Absorberschicht-Halbleitermaterial durch die Laserstrahlung am Bearbeitungsrand 9 der dritten Strukturierungslinien 7a, 7b zugeschrieben, der zu einer Umwandlung des Halbleitermaterials mit der Folge einer beträchtlichen Erhöhung von dessen elektrischer Leitfähigkeit führen kann. Ein solcher Kurzschlusspfad kann sich in ungünstigen Fällen vom Rückkontakt 2a, 2b, 2c bis zum Frontkontakt 8a, 8b, 8c der jeweiligen Einzelzelle 3a, 3b, 3c längs des Bearbeitungsrandes 9 der betreffenden dritten Strukturierungslinie 7a, 7b erstrecken und dadurch die Solarzelle 3a, 3b, 3c elektrisch kurzschließen, wie in Fig. 9 durch einen jeweiligen Kurzschluss-Oberflächenrandbereich 10a, 10b des Absorberschichtmaterials auf der linken Seite der dritten Strukturierungslinien 7a, 7b für die linke und die mittlere Solarzelle 3a, 3b gestrichelt angedeutet. Zwar kann sich ein gleicher elektrisch leitfähiger Pfad auch am in Fig. 9 rechten Rand jeder dritten Strukturierungslinie 7a, 7b ausbilden, dieser ist aber unschädlich, da hier ohnehin eine elektrisch leitende Verbindung zwischen Rückkontakt der einen Zelle und Frontkontakt der benachbarten Zelle aufgrund des die zweiten Strukturierungslinien 5a, 5b füllenden Frontkontaktschichtmaterials zwecks Serienverschaltung der Zellen 3a, 3b, 3c vorliegt.

Ein analoges Kurzschlussproblem kann beim sogenannten Entschichten derartiger Photovoltaikmodule mittels Laserstrahlung auftreten. Bei dieser Entschichtung wird ein randseitiger Teil oder auch ein anderer Bereich des Mehrschichtaufbaus über dem Substrat entfernt, einschließlich Absorberschicht und Frontkontaktschicht, um dort z.B. eine Moduleinfassung bzw. Modulverkapselung anbringen zu können oder ein Modul in mehrere separate Teilmodule auf einem gemeinsamen Substrat aufzuteilen.

Die Offenlegungsschrift DE 10 2004 016 313 A1 offenbart ein Verfahren und eine Einrichtung zur Herstellung von Einzelzellen aus einem flexiblen Band, das zuvor durchgehend mit einer Solarzellenschicht versehen wurde, wobei Randbereiche durch Ritzung in Längsrichtung des Bandes und quer verlaufende Schnittstellen des Bandes durch eine doppelte Ritzung abgetrennt werden, bevor das Band mechanisch oder durch Laserschnitt im Bereich zwischen der doppelten Ritzung in Einzelzellen zerlegt wird. Durch die Ritzung soll Kurzschlüssen zwischen Rückkontaktschicht und transparenter Frontkontaktschicht des Solarzellenbandes z.B. aufgrund von verbliebenen Metallspänen oder überschüssigem Frontkontaktschichtmaterial vorgebeugt werden. Die Ritzung wird hierbei durch die transparente Frontkontaktschicht hindurch eingebracht, wobei darauf geachtet wird, dass sie sich nicht vollständig durch die darunterliegende Absorberschicht hindurch erstreckt, um nicht Gefahr zu laufen, dass Rückkontaktschichtmaterial verdampft wird und hierdurch unerwünschte Kurzschlüsse entstehen.

Die Offenlegungsschriften US 2006/0266409 A1 , die als nächstliegenden Stand der Technik angeschen wird, WO 2008/050556 A1 und JP 2008-066453 A offenbaren jeweils einen Dünnschichtsolarzellen-Schichtaufbau, bei dem auf ein transparentes Trägersubstrat nacheinander eine transparente Frontkontaktschicht, eine Absorberschicht und eine Rückkontaktschicht aufgebracht sind. Zum Zwecke einer Randentschichtung wird zunächst in einem Hilfsschritt ein Hilfsgraben, der sich durch die Rückkontaktschicht und die gesamte Absorberschicht hindurch erstreckt, dadurch eingebracht, dass von der Substratseite her mit einer primär das Absorberschichtmaterial aufheizenden Laserstrahlung eingestrahlt wird, wodurch im bestrahlten Bereich das Absorberschichtmaterial aufgeheizt wird und verdampft und dabei das darüberliegende Rückkontaktsschichtmaterial mit wegreißt. In einem anschließenden Abtragsschritt wird wiederum von der Substratseite her mit einer anderen Laserstrahlung eingestrahlt, welche primär das Material der transparenten Frontkontaktschicht aufheizt, wodurch dieses verdampft und das darüberliegende Material der Absorberschicht und der Rückkontaktschicht mit entfernt.

Der Erfindung liegt als technisches Problem die Bereitstellung eines Verfahrens zugrunde, mit dem sich Schichtmaterial des eingangs erwähnten Schichtaufbaus mit den beiden elektrisch leitfähigen Schichten und der Zwischenschicht mittels Laserstrahlung mit vergleichsweise geringem Aufwand und funktionssicher unter Vermeidung von Kurzschlusspfaden in der Zwischenschicht von der einen zur anderen elektrisch leitfähigen Schicht gerade auch für die erwähnten Anwendungen der Entschichtung und der Trenngrabenstrukturierung von Photovoltaikmodulen abtragen lässt.

Die Erfindung löst dieses Problem durch die Bereitstellung eines Schichtmaterialabtragverfahrens mit den Merkmalen des Anspruchs 1. Bei diesem Verfahren wird vor dem eigentlichen Abtragschritt, in welchem das Schichtmaterial in einem vorgebbaren Sollabtraglinienbereich mittels Laserstrahlung abgetragen wird, ein Hilfsschritt durchgeführt, durch den entlang wenigstens einer Seite des Sollabtraglinienbereichs ein Hilfsgraben in das Schichtmaterial eingebracht wird. Dabei wird der Hilfsgraben direkt anschließend an den Seitenrand des Sollabtraglinienbereichs oder mit einem gewissen vorgebbaren lateralen Abstand von diesem eingebracht.

Dies hat zur Folge, dass nach Durchführen des Abtragschritts nicht nur das Material im Sollabtraglinienbereich bis zur dort gewünschten Tiefe entfernt ist, sondern zusätzlich auch das Schichtmaterial im seitlichen Hilfsgraben bis zu der für selbigen vorgebbaren Tiefe, einschließlich etwaigen Schichtmaterials im schmalen Bereich zwischen dem Sollabtraglinienbereich und dem Hilfsgraben, wenn letzterer mit etwas lateralem Abstand zum Sollabtraglinienbereich eingebracht wird. Dabei kann der Hilfsgraben im Abtragschritt als Sollbruchlinie fungieren, entlang der das abzutragende Schichtmaterial wenigstens der oberen elektrisch leitfähigen Schicht, z.B. der Frontkontaktschicht eines Photovoltaik-Mehrschichtaufbaus, in einer kontrollierten Weise abgesprengt werden kann, so dass die obere elektrisch leitfähige Schicht gegenüber dem Bearbeitungsrand der Zwischensicht zuverlässig elektrisch isoliert wird. Durch den Abtragschritt wird das Schichtmaterial typischerweise bis höchstens zum Trägersubstrat abgetragen, d.h. letzteres wird in diesem Fall durch den Abtragschritt nicht durchtrennt.

In den erwähnten Anwendungsfällen der Randentschichtung und Trenngrabenerzeugung für Photovoltaikmodule vermeidet dies die geschilderte Kurzschlussproblematik, da die Frontkontaktschicht durch den erzeugten Hilfsgraben lateral vom kurzschlussgefährdeten Absorberschicht-Bearbeitungsrand der betreffenden Strukturierungslinien beabstandet ist und dadurch elektrisch von diesem isoliert bleibt. Zudem kann der erzeugte Hilfsgraben zu einem erleichterten Abtragen des Schichtmaterials im Abtragschritt beitragen, was insbesondere auch für ein verbessertes Abtragen der Frontkontakt-Oberflächenschicht im erwähnten Fall von Photovoltaikmodulen gilt.

In einer Ausgestaltung der Erfindung nach Anspruch 2 wird der Hilfsgraben bis zu einer Tiefe eingebracht, die kleiner als eine Abtragtiefe im anschließenden Abtragschritt ist. Eine solche Hilfsgrabentiefe ist für viele Anwendungen zur Bereitstellung einer geeigneten Sollbruchlinie für den nachfolgenden Abtragschritt ausreichend, bei gleichzeitig minimiertem Aufwand für die Hilfsgrabenerzeugung. Eine geringe Hilfsgrabentiefe, die durchaus auch kleiner als die Dicke der oberen elektrisch leitfähigen Schicht sein kann, hat zudem den Vorteil, dass bei Verwendung von Laserstrahlung zur Erzeugung des Hilfsgrabens eine übermäßige Einwirkung der Laserstrahlung auf die Zwischenschicht mit der Gefahr einer Bildung entsprechender Kurzschlusspfade in diesem Verfahrensschritt vermieden werden kann. Alternativ kann für entsprechende Anwendungen vorgesehen sein, die Hilfsgrabentiefe im Wesentlichen gleich der Abtragtiefe für das während des Abtragschritts im Sollabtraglinienbereich zu entfernende Schichtmaterial zu wählen.

In einer weiteren Ausgestaltung der Erfindung wird nach Anspruch 3 je ein Hilfsgraben entlang jeder der beiden Seitenbereiche des Sollabtraglinienbereichs erzeugt, so dass beidseits eine Sollbruchlinie vorgegeben ist, wenn durch den anschließenden Abtragschritt das Schichtmaterial mittels Laserstrahlung im dazwischenliegenden Sollabtraglinienbereich entfernt wird, indem es durch die Laserstrahlungswirkung verdampft und/oder abgesprengt wird.

In einer Weiterbildung der Erfindung nach Anspruch 4 wird der Hilfsgraben mittels Laserstrahlung eingebracht. Dies kann gegenüber einer alternativ möglichen Einbringung z.B. durch ein mechanisches Verfahren den Fertigungsaufwand verringern. In einer Ausgestaltung dieser Verfahrensvariante gemäß Anspruch 5 wird zum Einbringen des Hilfsgrabens eine andere Laserstrahlung als im Abtragschritt gewählt. Damit kann die Laserstrahlung jeweils auf das Einbringen des Hilfsgrabens bzw. auf den Schichtmaterialabtrag im anschließenden Abtragschritt hin optimiert werden.

Eine Weiterbildung nach Anspruch 6 richtet sich auf eine Anwendung der Erfindung zur Trenngrabenstrukturierung bei der Fertigung eines integriert serienverschalteten Photovoltaikmoduls. Erfindungsgemäß können die zellenaufteilenden Trenngräben mit relativ geringem Aufwand mittels Laserstrahlung erzeugt werden, wobei Kurzschlussprobleme durch das vorherige Einbringen des Hilfsgrabens verhindert werden.

Eine Weiterbildung nach Anspruch 7 richtet sich speziell auf eine Anwendung der Erfindung zur randseitigen oder nicht randseitigen Entschichtung eines Photovoltaikmodul-Mehrschichtaufbaus auf einem Substrat, wobei auch hier der Realisierungsaufwand durch die Benutzung von Laserstrahlung relativ gering gehalten werden kann und durch den Hilfsgraben Kurzschlussprobleme vermieden werden und der Materialabtrag im Abtragschritt erleichtert wird.

In einer Ausgestaltung der Erfindung nach Anspruch 8 wird die Laserstrahlung im Abtragschritt von einer Rückseite des Photovoltaikmodulsubstrats her eingestrahlt, was in bestimmten Fällen von Vorteil sein kann, z.B. hinsichtlich Anordnen der gesamten Verfahrensapparatur, hinsichtlich des Prozessablaufs von Hilfsschritt und Abtragsschritt und/oder hinsichtlich Abtragverhaltens des abzutragenden Schichtmaterials.

In einer Ausgestaltung der Erfindung nach Anspruch 9 wird für die erwähnten Anwendungen bei Photovoltaikmodulen die Laserstrahlung für den Abtragschritt so gewählt, dass sich eine hohe Laserstrahlungsabsorption in der photovoltaisch aktiven Schicht bei gleichzeitig allenfalls schwacher Absorption durch die Frontkontaktschicht ergibt.

In einer Weiterbildung der Erfindung nach Anspruch 10 wird für die erwähnten Anwendungen bei Photovoltaikmodulen der Hilfsgraben mittels Laserstrahlung eingebracht, deren Parameter hinsichtlich hoher oberflächennaher Absorption durch die Frontkontaktschicht optimiert werden, insbesondere hinsichtlich Wellenlänge und/oder Leistungsdichte bzw. Pulsdauer, wobei gleichzeitig bei Bedarf die Laserstrahlung so eingestellt werden kann, dass die darunterliegende Absorberschicht durch die den Hilfsgraben erzeugende Laserstrahlung nicht signifikant beeinträchtigt wird.

Vorteilhafte, nachfolgend beschriebene Ausführungsformen der Erfindung sowie das zu deren besseren Verständnis oben erläuterte, herkömmliche Ausführungsbeispiel sind in den Zeichnungen dargestellt, in denen zeigen:
- Fig. 1: eine teilweise, idealisierte Querschnittansicht eines erfindungsgemäßen Photovoltaikmodul-Mehrschichtaufbaus,
- Fig. 2: ein Flussdiagramm zur Erläuterung eines erfindungsgemäßen Verfahrens zur Herstellung des Mehrschichtaufbaus von Fig. 1,
- Fig. 3: eine Querschnittansicht eines vorgefertigten Photovoltaik-Mehrschichtaufbaus vor Durchführung eines erfindungsgemäßen Hilfsschritts gemäß Fig. 2,
- Fig. 4: die Ansicht von Fig. 3 nach Durchführen des Hilfsschritts,
- Fig. 5: eine photographische Draufsicht auf einen erfindungsgemäß hergestellten Photovoltaik-Mehrschichtaufbau nach Art von Fig. 1,
- Fig. 6: eine teilweise, idealisierte Querschnittansicht eines Photovoltaik-Mehrschichtaufbaus in einem Randbereich vor Durchführen eines erfindungsgemäßen Hilfsschritts,
- Fig. 7: die Ansicht von Fig. 6 nach Durchführen des Hilfsschritts,
- Fig. 8: die Ansicht von Fig. 7 nach Durchführen eines Abtragschritts und
- Fig. 9: eine teilweise, idealisierte Querschnittansicht eines konventionell hergestellten Photovoltaik-Mehrschichtaufbaus mit Trenngrabenstrukturierung zwecks integrierter Serienverschaltung.

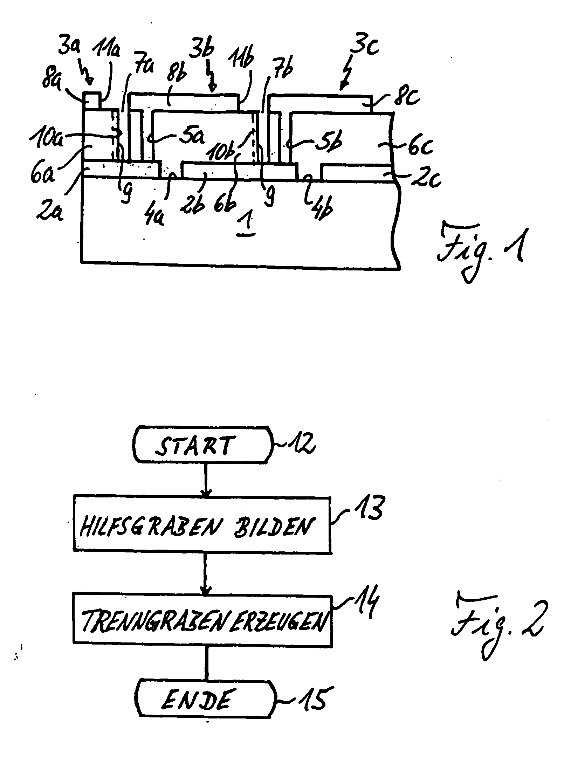

In Fig. 1 ist idealisiert ein hier interessierender Teil eines erfindungsgemäßen Photovoltaik-Schichtaufbaus in einer Querschnittansicht entsprechend Fig. 9 dargestellt, wobei der Einfachkeit halber für identische und funktionelle äquivalente Elemente gleiche Bezugszeichen verwendet sind und insoweit auf die obige Beschreibung zu Fig. 9 verwiesen werden kann. Im Unterschied zum konventionellen Beispiel von Fig. 9 ist beim erfindungsgemäßen Mehrschichtaufbau von Fig. 1 bei jeder der serienverschalteten Solarzellen 3a, 3b, 3c ein Hilfsgraben 11a, 11b vorhanden, der vor dem Einbringen der strukturierenden Trenngräben, d.h. der dritten Strukturierungslinien 7a, 7b, in die noch zusammenhängende Frontkontaktschicht eingebracht wird. Dabei sind die Hilfsgräben 11a, 11b im gezeigten Beispiel auf einer Seite, in Fig. 1 der linken Seite, eines jeweiligen Sollabtraglinienbereichs eingebracht, der durch die laterale Lage und Abmessung der strukturierenden Trenngräben 7a, 7b definiert ist.

Wie aus Fig. 1 zu erkennen, hat die erfindungsgemäße Maßnahme des Einbringens der Hilfsgräben 11a, 11b zur Folge, dass verglichen mit dem konventionellen Beispiel von Fig. 9 ein zusätzlicher Teil jedes Frontkontakts 8a, 8b, 8c über dem in Fig. 1 linken Bearbeitungsrand 9 der durch die Frontkontaktschicht 8a, 8b, 8c und die Absorberschicht 6a, 6b, 6c hindurch eingebrachten Trenngräben 7a, 7b entfernt ist. Selbst wenn daher bei der Erzeugung der Trenngräben 7a, 7b mittels geeigneter Laserstrahlung ein Kurzschlusspfad 10a, 10b an diesem Bearbeitungsrand 9 der Absorberschicht 6a, 6b, 6c entsteht, wird ein Kurzschluss zwischen Rückkontakt 2a, 2b, 2c und Frontkontakt 8a, 8b, 8c der jeweiligen Solarzelle 3a, 3b, 3c zuverlässig vermieden, indem der zugehörige Frontkontakt 8a, 8b, 8c einen durch den Hilfsgraben 11a, 11b vorgebbaren lateralen Abstand zu diesem Bearbeitungsrand 9 bzw. zu der dort eventuell gebildeten, kurzschlussgefährdenden Zone 10a im Halbleitermaterial der Absorberschicht 6a, 6b, 6c einhält.

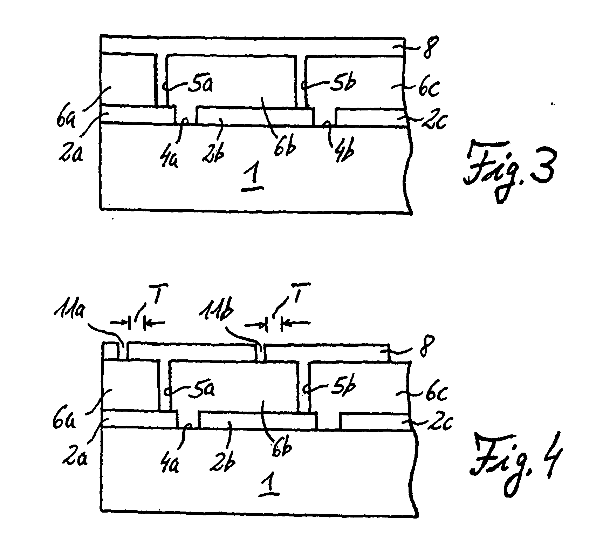

Die Fig. 2 bis 4 veranschaulichen den erfindungsgemäßen Teil des zum Mehrschichtaufbau von Fig. 1 führenden Herstellungsverfahrens. Ein Startschritt 12 beinhaltet die Bereitstellung eines Vorprodukts herkömmlicher Art, wie es in Fig. 3 gezeigt ist. Es stellt den Photovoltaik-Mehrschichtaufbau im Prozessstadium nach ganzflächigem Aufbringen einer Frontkontaktschicht 8 vor deren Aufteilung in die einzelnen Frontkontakte dar. In einem anschließenden Hilfsschritt 13 erfolgt dann das Einbringen der Hilfsgräben 11a, 11b in die Frontkontaktschicht 8, wie in Fig. 4 illustriert. Jeder Hilfsgraben 11a, 11b wird entlang einer Seite, in Fig. 4 der linken Seite, eines Sollabtraglinienbereichs T eingebracht, der durch die laterale Lage der später einzubringenden Trenngräben definiert ist. Dabei werden die Hilfsgräben 11a, 11b ohne oder alternativ mit einem vorgebbaren lateralen Abstand zum jeweiligen Sollabtraglinienbereich T und bis zu einer vorgebbaren Hilfsgrabentiefe eingebracht, die je nach Bedarf und Anwendungsfall geeignet gewählt wird. Im gezeigten Beispiel von Fig. 4 ist gemäß der Erfindung die Hilfsgrabentiefe gleich der Dicke der Frontkontaktschicht 8 gewählt, d.h. die Hilfsgräben 11a, 11b erstrecken sich durch die Frontkontaktschicht 8 hindurch bis zur Oberseite der Absorberschicht 6a, 6b, 6c. In alternativen Ausführungsbeispielen erstreckt sich der jeweilige Hilfsgraben auch nur bis zu einer gewissen Tiefe kleiner als die Frontkontaktschichtdicke in die Frontkontaktschicht oder mit einer gegenüber der Frontkontaktschichtdicke etwas größeren Tiefe noch geringfügig bis in die Absorberschicht 6a, 6b, 6c hinein.

In einem anschließenden Abtragschritt 14 erfolgt die Erzeugung der Trenngräben 7a, 7b durch Einstrahlen geeigneter Laserstrahlung in den Sollabtraglinienbereich T jeder Zelle 3a, 3b, 3c, so dass das dort befindliche Schichtmaterial der Frontkontaktschicht 8 und der darunterliegenden Absorberschicht 6a, 6b, 6c durch Verdampfen und/oder Absprengen abgetragen wird. Am Ende 15 dieses Prozessschritts liegt dann der Photovoltaik-Mehrschichtaufbau mit der in Fig. 1 gezeigten Struktur vor. Wenngleich im gezeigten Beispiel die Trenngräben 7a, 7b durch die Absorberschicht 6a, 6b, 6c hindurch bis zur Rückkontaktschicht 2a, 2b, 2c eingebracht sind, ist die Trenngrabentiefe unkritisch, solange sie das sichere Entfernen des Frontkontaktschichtmaterials im Sollabtraglinienbereich T jeder Zelle 3a, 3b, 3c und damit die Aufteilung der Frontkontaktschicht 8 in die separaten Frontkontakte 8a, 8b, 8c gewährleistet. Mit anderen Worten kann bereits eine Tiefe für die Trenngräben 7a, 7b ausreichen, die gleich der Frontkontaktschichtdicke ist oder in die Absorberschicht 6a, 6b, 6c hineinreicht, ohne diese vollständig bis zur Rückkontaktschicht 2a, 2b, 2c zu durchdringen. Eine präzise Steuerung der Trenngrabendicke ist daher nicht zwingend erforderlich, solang sichergestellt ist, dass sie mindestens gleich der Frontkontaktschichtdicke ist. Das Einbringen der Trenngräben 7a, 7b wie gezeigt durch die gesamte Absorberschichtdicke hindurch bis zu den Frontkontakten 2a, 2b, 2c kann z.B. in Fällen zweckmäßig sein, in denen Bedarf besteht, die Querleitfähigkeit der Absorberschicht 6a, 6b, 6c zu reduzieren.

Die erfindungsgemäß eingebrachten Hilfsgräben 11a, 11b fungieren im Abtragschritt, in dem die Trenngräben erzeugt werden, als jeweilige Sollbruchlinie, entlang der die Frontkontaktschicht kontrolliert abbrechen und daher im Sollabtraglinienbereich und ggf. im Bereich lateral zwischen Hilfsgraben und Sollabtraglinienbereich kontrolliert abgesprengt werden kann. Der Hilfsgraben 11a, 11b sorgt für eine ausreichende mechanische Schwächung der Frontkontaktschicht 8 im entsprechenden Bereich, wozu auch schon eine Hilfsgrabentiefe kleiner als die Frontkontaktschichtdicke genügen kann. Durch die Einwirkung der Laserstrahlung im anschließenden Abtragschritt kommt es innerhalb des Sollabtraglinienbereichs T zu einer starken lokalen Erhitzung und Volumenausdehnung des dortigen Schichtmaterials und insbesondere des Absorberschichtmaterials, was eine nach oben bzw. außen gerichtete Kraft auf die Frontkontakt-Oberflächenschicht in diesem Bereich verursacht. Durch die mechanische Schwächung der Frontkontaktschicht 8 aufgrund der eingebrachten Hilfsgräben 11a, 11b wird das Ablösen bzw. Absprengen der Frontkontaktschicht im Sollabtraglinienbereich mit vergleichsweise geringer erforderlicher Absprengkraft und in einem von den Hilfsgräben 11a, 11b genau definierten Bereich ermöglicht.

Der jeweilige Hilfsgraben 11a, 11b kann durch irgendeine hierfür geeignete Technik eingebracht werden. Dies schließt mechanische und photolithographische Verfahren ebenso ein wie die Möglichkeit, den Hilfsgraben 11a, 11b mittels Laserstrahlung einzubringen, wobei die Laserstrahlungsparameter geeignet gewählt werden, um den von der Trenngrabenerzeugung im anschließenden Abtragschritt unterschiedlichen Anforderungen gerecht zu werden. Insbesondere wird die Laserstrahlcharakteristik auf einen vergleichsweise oberflächennahen Energieeintrag eingestellt, um die Hilfsgräben 11a, 11b zu erzeugen, ohne das darunterliegende Halbleitermaterial der Absorberschicht 6a, 6b, 6c störend zu beeinflussen. Dazu kann z.B. Laserstrahlung mit einer Wellenlänge eingesetzt werden, für die das Kontaktschichtmaterial eine hohe Absorption aufweist. Für ein ZnO-Material, wie es häufig als Frontkontaktschichtmaterial eingesetzt wird, ist z.B. Laserstrahlung mit Wellenlängen im Bereich von ca. 355nm oder darunter oder mit einer Wellenlänge oberhalb von ca. 1500nm verwendbar. Zusätzlich oder alternativ kann zur Erzielung oberflächennaher Absorption Laserstrahlung mit vergleichsweise hoher Leistungsdichte unter Verwendung eines gepulsten Lasers mit kurzer Pulsdauer eingesetzt werden. Die Pulsdauer wird dabei insbesondere so kurz gewählt, dass während eines jeweiligen Pulses noch kein merklicher störender Wärmeeintrag in das Halbleitermaterial der Absorberschicht 6a, 6b, 6c durch Wärmeleitung erfolgt. Ein weiterer Vorteil einer Laserstrahlung mit kurzen intensiven Laserpulsen ist die dadurch bewirkte schlagartige lokale thermische Ausdehnung und explosive Verdampfung des Frontkontaktschichtmaterials im Hilfsgrabenbereich. Die dadurch induzierten mechanischen Kräfte können zur Bildung von feinen Längs- und Querrissen im Frontkontaktschichtmaterial führen, was das spätere Brechen desselben in kleinere Stücke während des Absprengens im anschließenden Abtragschritt erleichtert. Ein störender Einfluss der Laserstrahlung auf die Absorberschicht bzw. allgemeiner auf die Zwischenschicht zwischen oberer elektrisch leitfähiger Schicht, hier der Frontkontaktschicht, und unterer elektrisch leitfähiger Schicht, hier der Rückkontaktschicht, kann während der Hilfsgrabenerzeugung auch dadurch vermieden werden, dass die Hilfsgrabentiefe kleiner als die Dicke der oberen elektrisch leitfähigen Schicht gehalten wird, d.h. der Hilfsgraben nur in die obere elektrisch leitfähige Schicht, aber nicht vollständig durch diese hindurch bis zur Zwischenschicht eingebracht wird.

In einer entsprechenden Verfahrensvariante bezüglich des Abtragschritts 14 wird zur Trenngrabenerzeugung Laserstrahlung mit einer Wellenlänge verwendet, die so gewählt ist, dass die Laserstrahlung in der Frontkontaktschicht noch nicht merklich absorbiert wird, sondern erst im darunterliegenden Absorberschicht-Halbleitermaterial. Es entsteht dann ein relativ hoher Druck durch verdampfendes Absorbermaterial unter der anfangs des Abtragschritts im Sollabtraglinienbereich T noch geschlossenen Frontkontaktschicht, wodurch vorteilhafterweise eine hohe Kraftentwicklung zum Absprengen der oberflächlichen Frontkontaktschicht im Sollabtraglinienbereich generiert wird.

Im gezeigten Beispiel schließt sich der jeweilige Hilfsgraben 11a, 11b direkt, d.h. ohne lateralen Abstand, an den Sollabtraglinienbereich T an, der die Lage und Breite des einzubringenden Trenngrabens repräsentiert. Alternativ ist es auch möglich, den Hilfsgraben mit etwas lateralem Abstand zum Sollabtraglinienbereich einzubringen. Das zwischenliegende Frontkontaktschichtmaterial wird dann im anschließenden Abtragschritt auch in diesem schmalen Zwischenbereich zwischen Hilfsgraben und Sollabtraglinienbereich zuverlässig abgesprengt. Der Hilfsgraben dient folglich dazu, den Absprengbereich des Frontkontaktschichtmaterials im Abtragschritt als Sollbruchlinie direkt an der Seite des Sollabtraglinienbereichs oder mit geringfügigem Abstand davon festzulegen, d.h. den lateralen Abstand des verbleibenden Frontkontakts 8a, 8b, 8c vom zugewandten Bearbeitungsrand 9 des Trenngrabens 7a, 7b gemäß Fig. 1.

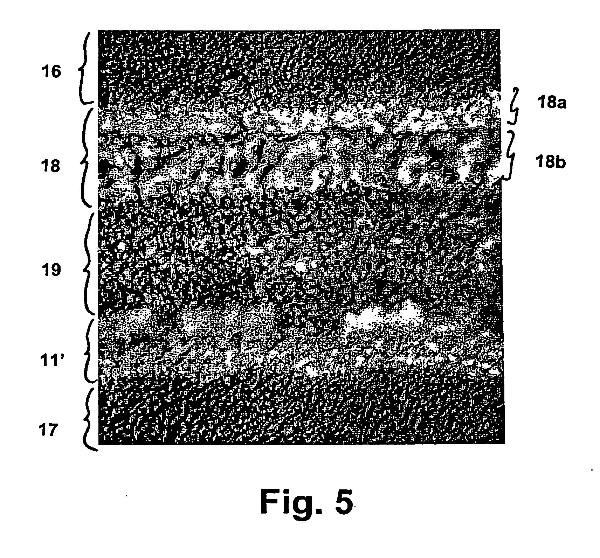

Fig. 5 zeigt in einer Draufsicht eine mikroskopische Aufnahme auf einen erfindungsgemäß prozessierten Photovoltaik-Mehrschichtaufbau. In einem oberen Abschnitt 16 und einem unteren Abschnitt 17 von Fig. 5 ist jeweils die unveränderte Oberfläche der Frontkontaktschicht 8 zu erkennen. Anschließend an den unteren Bereich 17 ist noch ein unterer Teil 11' eines in das Frontkontaktschichtmaterial eingebrachten Hilfsgrabens zu erkennen. Anschließend an den oberen Abschnitt 16 ist in Fig. 5 ein Abtragspurbereich 18 aus Randzone 18a und eigentlicher Abtragspur 18b zu erkennen, der den eingebrachten, strukturierenden Trenngraben der zugehörigen Solarzelle repräsentiert. Ein mittlerer Bereich 19 von Fig. 5 repräsentiert eine Zone mit abgesprengtem Frontkontaktmaterial, durch die somit das Frontkontaktschichtmaterial einer Solarzelle im unteren Abschnitt 17 von Fig. 5 ausreichend vom Trenngrabenbereich 18 der gleichen Solarzelle beabstandet und damit zuverlässig elektrisch isoliert gehalten ist. Der Abstand zwischen der Mitte der Hilfsspur und der Mitte der Abtragspur kann z.B. typischerweise einige 10µm betragen, beispielsweise etwa 40µm. Im rechten Teil von Fig. 5 ist noch ein herausgesprengter Frontkontaktschichtpartikel 20 zu erkennen, der sich in einer erhöhten Lage befindet und daher unscharf abgebildet ist.

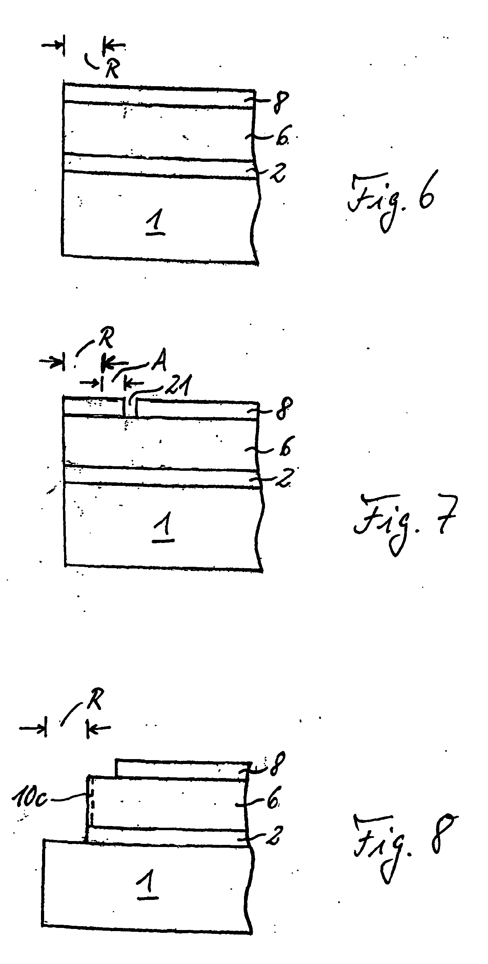

Die Fig. 6 bis 8 veranschaulichen als weitere mögliche Anwendung der Erfindung eine mit Hilfe des erfindungsgemäßen Schichtmaterialabtragverfahrens realisierte Randentschichtung für einen Photovoltaik-Mehrschichtaufbau nach Art von Fig. 1. Zunächst wird wieder ein Vorprodukt entsprechend Fig. 3 gefertigt, mit im gezeigten Randbereich unstrukturierter Rückkontaktschicht 2 und Absorberschicht 6, wie in Fig. 6 veranschaulicht. Bei diesem soll nun eine Randentschichtung des Schichtaufbaus über dem Substrat 1 innerhalb einer vorgebbaren Randzonenbreite R vorgenommen werden. Dazu wird zunächst, wie in Fig. 7 veranschaulicht, ein Hilfsgraben 21 entlang der inneren Seite der zu entschichtenden Randzone R in die Frontkontaktschicht 8 eingebracht, und zwar mit einem gewissen vorgebbaren Abstand A von der Randzone R, wozu die oben zu den Hilfsgräben 11a, 11b für die Trenngrabenerzeugung erläuterten Techniken in gleicher Weise verwendbar sind.

Daraufhin wird das Schichtmaterial im Randzonenbereich R über dem Substrat 1 im entsprechenden Abtragschritt mittels Laserstrahlung abgetragen, wobei auch das Frontkontaktschichtmaterial zwischen dem Randzonenbereich R und dem Hilfsgraben 21 abgesprengt wird. Fig. 8 zeigt das so erhaltene Produkt mit entschichteter Randzone R. Durch das Absprengen des Frontkontaktschichtmaterials im Bereich zwischen Randzone R und Hilfsgraben 21, wobei es auch im Bereich des Hilfsgrabens 21 selbst entfernt wird, erstreckt sich die Frontkontaktschicht 8 beim randentschichteten Produkt nicht bis zur Randkante der Frontkontaktschicht 2 und der Absorberschicht 6, sondern endet mit lateralem Abstand vor dieser. Daher wird auch in dieser Anwendung zuverlässig eine Kurzschlussbildung zwischen Frontkontaktschicht 8 und Rückkontaktschicht 2 vermieden, selbst wenn durch den Schichtabtragprozess entlang der Randkante der Absorberschicht 6 ein elektrisch leitfähiger Kurzschlusspfad 10c entsprechend den Kurzschlusspfaden 10a, 10b bei der oben erläuterten Trenngrabenstrukturierung gebildet wird, wie in Fig. 8 gestrichelt angedeutet.

Im entschichteten Abtragschritt kann die Laserstrahlung je nach Bedarf und Anwendungsfall von vorne, d.h. von der Frontkontaktschicht her, oder alternativ von hinten, d.h. von einer Substratrückseite her, eingestrahlt werden, d.h. in Fig. 7 von unten. Hingegen erfolgt die Einbringung des Hilfsgrabens 21 auch im Fall der Randentschichtung von vorn, d.h. direkt auf die oberflächliche Frontkontaktschicht 8. In entsprechenden Ausführungsformen kann das Abtragen des Schichtmaterials im Randbereich R in einem gleichen Prozessdurchlauf mit dem Einbringen des Hilfsgrabens 21 erfolgen, wozu lediglich die Laserstrahlung zum Einbringen des Hilfsgrabens 21 in Bearbeitungsrichtung mit geeignetem Vorlauf vor der von vorn oder hinten zum Abtragen des Schichtmaterials im Randbereich R eingestrahlten Laserstrahlung geführt wird. Diese quasi zeitgleiche und lediglich örtlich etwas versetzte Durchführung des Hilfsschritts zum Einbringen des jeweiligen Hilfsgrabens und des Abtragschritts zum Abtragen des Schichtmaterials im entsprechenden Sollabtraglinienbereich eignet sich in gleicher Weise auch für andere Verfahrensvarianten, insbesondere auch für die Trenngrabenstrukturierung gemäß den Fig. 1 bis 4.

In gleicher Weise wie oben am Beispiel einer Randentschichtung erläutert, kann auch ein anderer, insbesondere linienförmiger, nicht randseitiger Bereich eines Photovoltaik-Mehrschichtaufbaus auf einem Substrat entschichtet werden, wobei in diesem Anwendungsfall vorzugsweise zwei Hilfsgräben beidseits des zu entschichtenden linienförmigen Bereichs vorgesehen werden. Eine solche nicht randseitige Entschichtung kann beispielsweise dazu dienen, ein Modul in mehrere separate Teilmodule auf einem gemeinsamen Substrat aufzuteilen.

Während in den gezeigten Ausführungsbeispielen ein Hilfsgraben jeweils nur auf einer Seite des Sollabtraglinienbereichs eingebracht wird, umfasst die Erfindung in gleicher Weise auch Ausführungsformen, bei denen je ein Hilfsgraben entlang beider Längsseiten des Sollabtraglinienbereichs eingebracht wird. Dies ist in Fällen zweckmäßig, in denen Bedarf besteht, den Materialabtrag im Sollabtraglinienbereich zu beiden Seiten hin definiert zu begrenzen und/oder zu unterstützen, z.B. im Fall einer nicht randseitigen Entschichtung eines Photovoltaik-Mehrschichtaufbaus auf einem Substrat

Wenngleich sich die gezeigten Ausführungsbeispiele auf die Trenngrabenstrukturierung und Randentschichtung eines Photovoltaik-Mehrschichtaufbaus beziehen, versteht es sich, dass die Erfindung in gleicher Weise für andere Anwendungsgebiete bei Photovoltaikmodulen und beliebigen anderen Bauelementen verwendbar ist, bei denen Schichtmaterial eines Schichtaufbaus auf einem Trägersubstrat, der eine untere und eine obere elektrisch leitfähige Schicht und eine zwischenliegende, ein- oder mehrlagige Zwischenschicht beinhaltet, mittels Laserstrahlung definiert in einem vorgebbaren lateralen Bereich abgetragen werden soll. Dabei ermöglicht die Erfindung eine zuverlässige Vermeidung von elektrischen Kurzschlusspfaden gerade auch in Fällen, in denen das Zwischenschichtmaterial unter der Einwirkung der Laserstrahlung zur Ausbildung solcher Kurzschlussfade neigt.

## Patentansprüche

1. Verfahren zum Abtragen von Schichtmaterial eines Schichtaufbaus auf einem Trägersubstrat (1) in einem Sollabtraglinienbereich (T, R), wobei der Schichtaufbau eine untere (2a, 2b, 2c; 2) und eine obere elektrisch leitfähige Schicht (8a, 8b, 8c; 8) und zwischen diesen befindliches ein- oder mehrlagiges Zwischenschichtmaterial (6) umfasst, mit folgenden Schritten:
- einem Hilfsschritt (13), in dem entlang wenigstens einer Seite des Sollabtraglinienbereichs ein Hilfsgraben (11a, 11 b, 21) in das Schichtmaterial wenigstens der oberen elektrisch leitfähigen Schicht (8a, 8b, 8c; 8) bis zu einer Tiefe in den Schichtaufbau eingebracht wird, die gleich groß wie oder kleiner als die Dicke der oberen elektrisch leitfähigen Schicht (8a, 8b, 8c; 8) ist oder die größer als die Dicke der oberen elektrisch leitfähigen Schicht (8a, 8b, 8c; 8) ist und sich noch geringfügig in das Zwischenschichtmaterial (6) hinein erstreckt, und
- einem Abtragschritt (14), in dem Laserstrahlung auf das Schichtmaterial im Sollabtraglinienbereich lateral neben dem Hilfsgraben (11a, 11b, 21) derart eingestrahlt wird, dass im Sollabtraglinienbereich befindliches Schichtmaterial mindestens in der Dicke der oberen elektrisch leitfähigen Schicht (8a, 8b, 8c, 8) abgetragen wird,
- wobei das Schichtmaterial durch den Abtragschritt höchstens bis zum Trägersubstrat (1) abgetragen wird und/oder wobei der Hilfsgraben (11a, 11b, 21) mit vorgebbarem lateralem Abstand (A) vom Sollabtraglinienbereich eingebracht wird und im Abtragschritt als Sollbruchlinie zum elektrisch isolierenden Absprengen von Schichtmaterial der oberen elektrisch leitfähigen Schicht (8a, 8b, 8c; 8) wenigstens im Bereich lateral zwischen dem Hilfsgraben (11a, 11b, 21) und dem Sollabtraglinienbereich mittels der Laserstrahlung fungiert.

2. Verfahren nach Anspruch 1, weiter **dadurch gekennzeichnet, dass** der Hilfsgraben (11a, 11b, 21) bis zu einer Tiefe eingebracht wird, die kleiner als eine Abtragtiefe des Schichtmaterials im Sollabtraglinienbereich während des Abtragschritts (14) ist.

3. Verfahren nach Anspruch 1 oder 2, weiter **dadurch gekennzeichnet, dass** je ein Hilfsgraben (11a, 11b, 21) entlang jeder von zwei gegenüberliegenden Seiten des Sollabtraglinienbereichs während des Hilfsschritts (13) eingebracht wird.

4. Verfahren nach einem der Ansprüche 1 bis 3, weiter **dadurch gekennzeichnet, dass** der Hilfsgraben (11a, 11b, 21) mittels Laserstrahlung eingebracht wird.

5. Verfahren nach Anspruch 4 **dadurch gekennzeichnet, dass** der Hilfsgraben (11a, 11b, 21) mittels einer Laserstrahlung eingebracht wird, die sich hinsichtlich Wellenlänge und/oder Leistungsdichte und/oder Pulsdauer von der Laserstrahlung während des Abtragschritts (14) unterscheidet.

6. Verfahren nach einem der Ansprüche 1 bis 5, weiter **dadurch gekennzeichnet, dass** die obere elektrisch leitfähige Schicht (8) eine Frontkontaktschicht eines Photovoltaik-Mehrschichtaufbaus auf dem Trägersubstrat ist und der Sollabtraglinienbereich ein Trenngraben (7a, 7b) ist, der wenigstens durch die Frontkontaktschicht hindurch eingebracht wird.

7. Verfahren nach einem der Ansprüche 1 bis 6, weiter **dadurch gekennzeichnet, dass** der Sollabtraglinienbereich ein zu entschichtender Bereich eines Photovoltaik-Mehrschichtaufbaus auf dem Trägersubstrat (1) ist, wobei die obere elektrisch leitfähige Schicht eine Frontkontaktschicht (8) des Photovoltaik-Mehrschichtaufbaus ist und das ein- oder mehrlagige Zwischenschichtmaterial eine Absorberschicht (6) des Photovoltaik-Mehrschichtaufbaus beinhaltet.

8. Verfahren nach einem der Ansprüche 1 bis 7, weiter **dadurch gekennzeichnet, dass** die Laserstrahlung im Abtragschritt von einer Trägersubstratrückseite her eingestrahlt wird.

9. Verfahren nach einem der Ansprüche 6 bis 8, weiter **dadurch gekennzeichnet, dass** die Laserstrahlung im Abtragschritt (14) mit einer Wellenlänge eingestrahlt wird, die selektiv für Absorption durch die Absorberschicht ausgewählt wird.

10. Verfahren nach einem der Ansprüche 6 bis 9, weiter **dadurch gekennzeichnet, dass** die Laserstrahlung im Hilfsschritt selektiv für Absorption in der Frontkontaktschicht ausgewählt wird.

## Claims

1. A method for removing layered material of a layered structure on a support substrate (1) in a predetermined removal line region (T, R), the layered structure including a lower (2a, 2b, 2c; 2) and an upper electrically conductive layer (8a, 8b, 8c; 8) and interposed between them a monolayer or multilayer intermediate layer material (6), comprising the following steps:
- an auxiliary step (13), wherein along at least one side of the predetermined removal line region an auxiliary trench (11a, 11b, 21) is formed in the layered material of at least the upper electrically conductive layer (8a, 8b, 8c; 8) down to a depth in the layered structure that is equal to or smaller than the thickness of the upper electrically conductive layer (8a, 8b, 8c; 8) or that is greater than the thickness of the upper electrically conductive layer (8a, 8b, 8c; 8) and yet reaching into the intermediate layer material (6) to a minor extent, and
- a removal step (14), wherein laser radiation is irradiated onto the layered material in the predetermined removal line region laterally adjacent to the auxiliary trench (11a, 11b, 21) in such a manner that layered material located in the predetermined removal line region is removed at least in the thickness of the upper electrically conductive layer (8a, 8b, 8c; 8),
- wherein by means of the removal step the layered material is removed at most down to the support substrate (1) and/or wherein the auxiliary trench (11 a, 11 b, 21) is formed with a predefined lateral distance (A) to the predetermined removal line region and during the removal step serves as a predetermined break line for electrically insulating fragmentation of layered material of the upper electrically conductive layer (8a, 8b, 8c; 8) at least in the region located laterally between the auxiliary trench (11a, 11b, 21) and the predetermined removal line region by means of laser radiation.

2. The method according to claim 1, further **characterized in that** the auxiliary trench (11 a, 11 b, 21) is formed down to a depth that is smaller than a removal depth of the layered material in the predetermined removal line region during the removal step (14).

3. The method according to claim 1 or 2, further **characterized in that** in each case one auxiliary trench (11 a, 11 b, 21) is formed along each of two opposed sides of the predetermined removal line region during the auxiliary step (13).

4. The method according to any of claims 1 to 3, further **characterized in that** the auxiliary trench (11 a, 11 b, 21) is formed by means of laser radiation.

5. The method according to claim 4, **characterized in that** the auxiliary trench (11 a, 11 b, 21) is formed by means of a laser radiation which in terms of wavelength and/or power density and/or pulse length is different from the laser radiation during the removal step (14).

6. The method according to any of claims 1 to 5, further **characterized in that** the upper electrically conductive layer (8) is a front contact layer of a photovoltaics multilayer structure on the support substrate and the predetermined removal line region is a separating trench (7a, 7b) formed at least through the front contact layer.

7. The method according to any of claims 1 to 6, further **characterized in that** the predetermined removal line region is a region to be delaminated of a photovoltaics multilayer structure on the support substrate (1), wherein the upper electrically conductive layer is a front contact layer (8) of the photovoltaics multilayer structure and the monolayer or multilayer intermediate layer material includes an absorber layer (6) of the photovoltaics multilayer structure.

8. The method according to any of claims 1 to 7, further **characterized in that** during the removal step the laser radiation is irradiated from a rear side of the support substrate.

9. The method according to any of claims 6 to 8, further **characterized in that** during the removal step (14) the laser radiation is irradiated using a wavelength that is preselected selectively for absorption by the absorber layer.

10. The method according to any of claims 6 to 9, further **characterized in that** during the auxiliary step the laser radiation is preselected selectively for absorption in the front contact layer.

## Revendications

1. Procédé d'enlèvement de couches de matériau d'une structure stratifiée sur un substrat porteur (1) dans une zone linéaire (T, R) d'enlèvement de consigne,
la structure stratifiée comportant une couche inférieure (2a, 2b, 2c; 2) et une couche supérieure (8a, 8b, 8c; 8) électriquement conductrice et un matériau intermédiaire (6) stratifié en une ou plusieurs couches entre ces couches, le procédé comportant les étapes suivantes :
une étape auxiliaire (13) au cours de laquelle un sillon auxiliaire (11a, 11b, 21) est formé dans la structure stratifiée le long d'au moins un côté de la zone linéaire d'enlèvement de consigne du matériau stratifié d'au moins la couche supérieure électriquement conductrice (8a, 8b, 8c; 8), jusqu'à une profondeur égale ou inférieure à l'épaisseur de la couche supérieure électriquement conductrice (8a, 8b, 8c; 8) ou supérieure à l'épaisseur de la couche supérieure électriquement conductrice (8a, 8b, 8c; 8) et encore légèrement dans le matériau (6) de la couche intermédiaire et
une étape d'enlèvement (14) au cours de laquelle un rayonnement laser est projeté latéralement à côté du sillon auxiliaire (11a, 11b, 21) sur le matériau stratifié dans la zone linéaire d'enlèvement de consigne de telle sorte que le matériau stratifié présent dans la zone linéaire d'enlèvement de consigne soit enlevé au moins jusqu'à l'épaisseur de la couche supérieure électriquement conductrice (8a, 8b, 8c; 8),
le matériau stratifié étant enlevé lors de l'étape d'enlèvement au plus jusqu'au substrat porteur (1) et/ou le sillon auxiliaire (11a, 11b, 21) étant formé à une distance latérale prédéterminée (A) de la zone linéaire d'enlèvement de consigne et, au cours de l'étape d'enlèvement, servant de ligne de rupture préférentielle pour détacher le matériau stratifié de la couche supérieure électriquement conductrice (8a, 8b, 8c; 8) au moins dans la zone latérale entre le sillon auxiliaire (11a, 11b, 21) et la zone linéaire d'enlèvement de consigne au moyen du rayonnement laser.

2. Procédé selon la revendication 1, **caractérisé en outre en ce que** le sillon auxiliaire (11a, 11b, 21) est formé jusqu'à une profondeur inférieure à la profondeur d'enlèvement du matériau stratifié dans la zone linéaire d'enlèvement de consigne pendant l'étape d'enlèvement (14).

3. Procédé selon les revendications 1 ou 2, **caractérisé en outre en ce que** pendant l'étape auxiliaire (13), un sillon auxiliaire (11a, 11b, 21) est formé le long de chacun des deux côtés opposés de la zone linéaire d'enlèvement de consigne.

4. Procédé selon l'une des revendications 1 à 3, **caractérisé en outre en ce que** le sillon auxiliaire (11a, 11b, 21) est formé au moyen d'un rayonnement laser.

5. Procédé selon la revendication 4, **caractérisé en ce que** le sillon auxiliaire (11a, 11b, 21) est formé au moyen d'un rayonnement laser dont la longueur d'onde et/ou la densité de puissance et/ou la durée des impulsions sont différentes de celles du rayonnement laser utilisé pendant l'étape d'enlèvement (14).

6. Procédé selon l'une des revendications 1 à 5, **caractérisé en outre en ce que** la couche supérieure électriquement conductrice (8) est une couche de contact frontal d'une structure stratifiée photovoltaïque multicouche sur le substrat porteur et **en ce que** la zone linéaire d'enlèvement de consigne est un sillon de séparation (7a, 7b) formé au moins à travers la couche de contact frontal.

7. Procédé selon l'une des revendications 1 à 6, **caractérisé en outre en ce que** la zone linéaire d'enlèvement de consigne est une zone à déstratifier d'une structure stratifiée photovoltaïque multicouche sur le substrat porteur (1), la couche supérieure électriquement conductrice étant une couche (8) de contact frontal de la structure stratifiée photovoltaïque multicouche et la ou les couches de matériau intermédiaire contenant une couche d'absorption (6) de la structure stratifiée photovoltaïque multicouche.

8. Procédé selon l'une des revendications 1 à 7, **caractérisé en outre en ce qu'**au cours de l'étape d'enlèvement, le rayonnement laser est projeté sur le côté dorsal du substrat porteur.

9. Procédé selon l'une des revendications 6 à 8, **caractérisé en outre en ce qu'**au cours de l'étape d'enlèvement (14), le rayonnement laser projeté a une longueur d'onde sélectionnée de telle sorte qu'il soit absorbé sélectivement par la couche d'absorption.

10. Procédé selon l'une des revendications 6 à 9, **caractérisé en outre en ce qu'**au cours de l'étape auxiliaire, le rayonnement laser est sélectionné de manière à être absorbé sélectivement dans la couche de contact frontal.
